# EUROPÄISCHE PATENTSCHRIFT

(11) **EP 0 761 717 B1**
(45) Veröffentlichungstag und Bekanntmachung des Hinweises auf die Patenterteilung: **06.06.2001**
(21) Anmeldenummer: 96113268.5
(22) Anmeldetag: 19.08.1996
(51) Int. Cl.: C08G 73/22, C08G 75/32, C08G 69/32, G03F 7/038

(54) **Verfahren zur Herstellung von Poly-o-hydroxyamiden und Poly-o-mercaptoamiden**
Process for the preparation of poly-o-hydroxyamides and poly-o-mercaptoamides
Procédé pour la préparation de poly-o-hydroxyamides et de poly-o-mercaptoamides

(30) Priorität: 31.08.1995 DE 19532202
(43) Veröffentlichungstag der Anmeldung: 12.03.1997
(73) Patentinhaber: Infineon Technologies AG, 81669 München (DE)
(72) Erfinder: Sezi, Recai, Dr., 91341 Röttenbach (DE); Ahne, Hellmut, Dr., 91341 Röttenbach (DE); Gestigkeit, Roland, Dipl.-Chem., 90478 Nürnberg (DE)
(74) Vertreter: Viering, Jentschura & Partner

(56) Entgegenhaltungen:
- US-A- 5 270 432

## Beschreibung

Die Erfindung betrifft ein Verfahren zur Herstellung von Poly-o-hydroxyamiden (Polybenzoxazol-Vorstufen) und Poly-o-mercaptoamiden (Polybenzothiazol-Vorstufen).

In der Mikroelektronik werden hochwärmebeständige Polymere benötigt, insbesondere als Schutz- und Isolierschichten bzw. als Dielektrika (siehe dazu beispielsweise: "SAMPE Journal", Vol. 25 (1989), No. 6, Seiten 18 bis 23, und "Proceedings of the 1992 International Conference on Multichip Modules", Seiten 394 bis 400). Einige der verwendeten Polymere, beispielsweise Homo- und Copolymere aromatischer Polyether sowie Vorstufen von Polyimiden (PI) und Polybenzoxazolen (PBO), weisen eine gute Löslichkeit in organischen Lösungsmitteln und gute Filmbildungseigenschaften auf und können mittels Schleudertechnik auf elektronische Bauteile aufgebracht werden (siehe dazu beispielsweise: "High Performance Polymers", Vol. 4 (1992), No. 2, Seiten 73 bis 80, und "Polymers for Advanced Technologies", Vol. 4 (1993), Seiten 217 bis 233).

Polymer-Vorstufen der genannten Art werden durch eine Temperaturbehandlung cyclisiert, d.h. in die entsprechenden Polymere (PI bzw. PBO) umgewandelt; dabei ergeben sich die endgültigen Eigenschaften. Durch die Cyclisierung verschwinden nämlich die hydrophilen Gruppierungen des Poly-o-hydroxyamids, d.h. die NH-, OH- und CO-Gruppen, welche die dielektrischen Eigenschaften und die Wasseraufnahme negativ beeinflussen würden. Dies ist beispielsweise ein wesentlicher Vorteil der Polybenzoxazole gegenüber den Polyimiden (mit zwei CO-Gruppen pro Imideinheit) und insbesondere gegenüber den Hydroxypolyimiden (mit zwei CO-Gruppen und einer OH-Gruppe pro Imideinheit). Außerdem ist die Cyclisierung nicht nur für die guten dielektrischen Eigenschaften und die geringe Wasseraufnahme des Endproduktes wichtig, sondern auch für dessen hohe Temperaturstabilität.

PI- und PBO-Vorstufen können, beispielsweise durch Zusatz geeigneter photoaktiver Komponenten, photosensitiv eingestellt und dann direkt strukturiert werden, d.h. ohne die Verwendung eines Hilfsresists. Dies ist deswegen bedeutsam, weil die direkte Strukturierung - im Vergleich mit der indirekten Strukturierung - erhebliche Kostenvorteile bietet.

Photosensitive PBO-Vorstufen bieten, im Gegensatz zu den meisten photosensitiven PI-Vorstufen, die Vorteile der positiven Strukturierbarkeit, wie geringere Defektdichte bei der Strukturierung der sogenannten "via holes", weil - im Vergleich mit negativ arbeitenden Systemen - nur ein Bruchteil der Fläche belichtet wird. Beim Einsatz alkalilöslicher PBO-Vorstufen ergibt sich außerdem die Möglichkeit einer wäßrig-alkalischen Entwicklung. Nach der Photostrukturierung erfolgt dann die Cyclisierung der Vorstufen durch Temperung.

Wäßrig-alkalisch entwickelbare PBO-Vorstufen sind bereits bekannt (siehe dazu: EP-PS 0 023 662, EP-OS 0 264 678 und EP-PS 0 291 779). Der dabei angewendete photolithographische Prozeß ist, bis auf die Cyclisierung, der gleiche wie bei der Strukturierung bekannter Positivresists auf der Basis von Novolaken und Chinonaziden, eines weltweit in zahlreichen Fertigungslinien eingesetzten Prozesses (siehe dazu beispielsweise: D.S. Soane und Z. Martynenko "Polymers in Microelectronics - Fundamentals and Applications", Elsevier, Amsterdam 1989, Seiten 77 bis 124).

Die Alkalilöslichkeit der PBO-Vorstufen ist eine wichtige Voraussetzung für deren Einsatz als Basispolymer für wäßrig-alkalisch entwickelbare photosensitive Dielektrika. Für mikroelektronische Anwendungen müssen die Vorstufen in metallionenfreien Entwicklern löslich sein, damit derartige Entwickler auch bei der Photostrukturierung verwendet werden können. Entwickler, welche Metallionen enthalten, können nämlich die elektrische Funktion der Bauteile negativ beeinflussen.

Die gängigste Methode zur Herstellung von alkalilöslichen PBO-Vorstufen, d.h. von Poly-o-hydroxyamiden, ist die Umsetzung eines Dicarbonsäurechlorids mit einem geeigneten Bis-o-aminophenol. Zum Abfangen des bei der Reaktion entstehenden Chlorwasserstoffs wird in der Regel eine lösliche Base, wie Pyridin, zugesetzt (siehe: EP-OS 0 264 678 und EP-PS 0 291 779). Nach dieser Methode sind nun zwar Vorstufen herstellbar, welche in metallionenfreien wäßrig-alkalischen Entwicklern löslich sind, von Nachteil ist jedoch, daß Chloridionen im Polymer verbleiben. Ein derartiges Polymer ist aber als Beschichtungsmaterial für mikroelektronische Bauteile nicht brauchbar, weil die Chloridionen Korrosion verursachen und die Funktion der Bauteile somit stark beeinträchtigen können. Es ist deshalb eine Reinigung des Polymers mittels Ionenaustauscher erforderlich. Diese Reinigung ist jedoch aufwendig und teuer, sie umfaßt nämlich zusätzliche Prozeßschritte, wie die Vorbereitung der Ionenaustauschersäule, das Lösen des Polymers, das Durchlaufen der Lösung durch die Säule und das Nachwaschen sowie die erneute Ausfällung und Trocknung.

Bei der Herstellung von Poly-o-hydroxyamiden muß auch die Forderung erfüllt werden, daß das Dicarbonsäurechlorid vorwiegend mit den Aminogruppen des Bis-o-aminophenols reagiert (unter Amidbildung), nicht aber mit dessen Hydroxylgruppen (unter Esterbildung), d.h. die Reaktionsselektivität der Amidbildung gegenüber der Esterbildung muß hoch sein. Kann die Esterbildung nicht ausgeschlossen bzw. stark unterdrückt werden, dann führt dies zu unzureichend alkalilöslichen Polymeren. Eine geringe Reaktionsselektivität kann ferner zu einer Gelbildung in der Polymerlösung führen, wobei das hergestellte Poly-o-hydroxyamid dann unfiltrierbar und somit unbrauchbar ist.

Es wurden auch bereits Verfahren zur chloridfreien Synthese von Poly-o-hydroxyamiden - und ebenso von Poly-o-mercaptoamiden - beschrieben. So ist es aus der EP-OS 0 158 726 bekannt, Dihydroxy- bzw. Dimercaptodiaminoverbindungen in Gegenwart eines Carbodiimids mit einer Dicarbonsäure umzusetzen. Bei dieser Reaktion bereiten jedoch Harnstoffreste, die aufgrund einer Umlagerungsreaktion am Harz verbleiben, oft Probleme. Sie beeinträchtigen nämlich die thermische Beständigkeit des Polybenzoxazols bzw. Polybenzothiazols sowie die Qualität der daraus hergestellten Schichten. Außerdem sind die nach diesem Verfahren hergestellten Polymere in metallionenfreien wäßrig-alkalischen Entwicklern nicht ausreichend löslich.

Ein alternatives chloridfreies Herstellungsverfahren für Poly-o-hydroxyamide besteht darin, zur Umsetzung der Dicarbonsäure mit dem Bis-o-aminophenol Kondensationsreagenzien wie 1-Ethoxycarbonyl-2-ethoxy-1,2-dihydrochinolin und 1,1'-Carbonyldioxy-di-1,2,3-benzotriazol einzusetzen (siehe: EP-OS 0 391 196). Die auf diese Weise hergestellten Polymere zeigen aber in metallionenfreien wäßrig-alkalischen Entwicklern ebenfalls nur eine unzureichende Löslichkeit.

Es sind auch Verfahren bekannt, bei denen die Amidbildung mittels Phosphorverbindungen erfolgt (siehe dazu: EP-OS 0 481 402, US-PS 4 331 592 und DE-OS 37 16 629). Bei Poly-o-hydroxyamiden führen derartige Synthesen aber entweder zu cyclisierten, d.h. alkaliunlöslichen Produkten oder es verbleiben im Polymer phosphorhaltige, teilweise auch chemisch gebundene Reste, wodurch das Polymer, wegen der Dotierungseigenschaften von Phosphor, für mikroelektronische Anwendungen unbrauchbar wird. Im Gegensatz zu ionischen Verunreinigungen können nämlich derartige Reste beispielsweise nicht mittels Ionenaustauscher entfernt werden.

Aufgabe der Erfindung ist es, ein kostengünstiges Verfahren anzugeben, mit dem - auf chloridfreiem Weg - Poly-o-hydroxyamide und Poly-o-mercaptoamide hergestellt werden können, welche in metallionenfreien wäßrig-alkalischen Entwicklern löslich sind.

Dies wird erfindungsgemäß dadurch erreicht, daß ein Bis-o-hydroxyamid bzw. ein Bis-o-mercaptoamid der Struktur 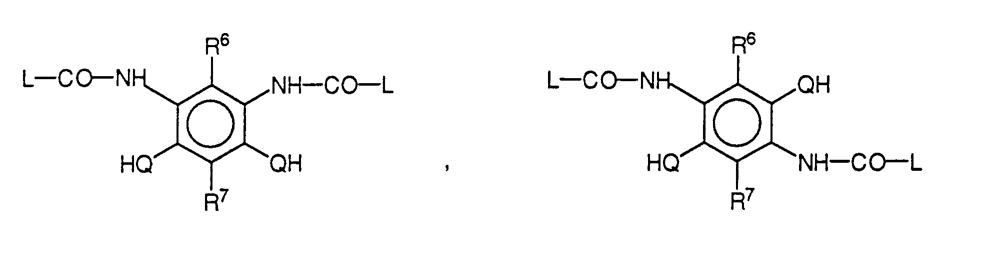 oder 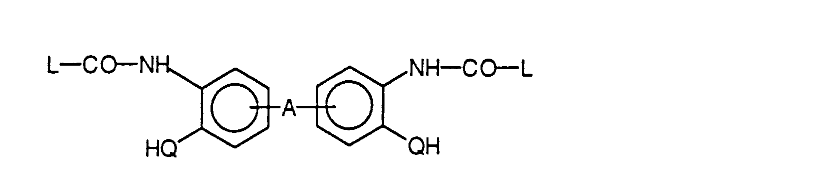 in Gegenwart eines basischen Katalysators mit einer Dihydroxyverbindung der Struktur

HO-R*-OH

umgesetzt wird, wobei folgendes gilt:
- Q =: O oder S;
- R⁶ und R⁷ =: H, F, CH₃, CF₃, CN oder NO₂ (unabhängig voneinander);
- A =: (CH₂)ₙ, (CF₂)ₚ, C(CH₃)₂, C(CF₃)₂, C(CH₃)(C₆H₅), C(CF₃)(C₆H₅), C(CF₃)(C₆F₅), C(C₆H₅)₂, CF₂-CF(CF₃), CH=CH, CF=CF, C≡C, O-C₆H₄-O, O, S, CO oder SO₂,
wobei n = 0 bis 10 und p = 1 bis 10; 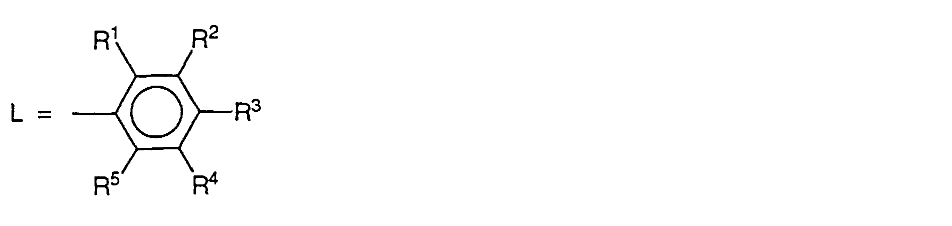 R¹, R², R³, R⁴ und R⁵ sind - unabhängig voneinander - H, F, CN oder NO₂, wobei mindestens einer der Reste R¹ bis R⁵ F, CN oder NO₂ ist und höchstens zwei der Reste R¹ bis R⁵ CN bzw. NO₂ sind;
R* hat folgende Bedeutung:
- (CR₂)ₘ mit R = H, F, CH₃ oder CF₃
und m = 1 bis 10; 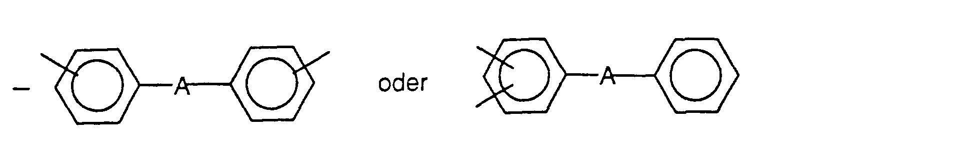
mit A = (CH₂)ₙ, (CF₂)ₚ, C(CH₃)₂, C(CF₃)₂, C(CH₃)(C₆H₅), C(CF₃)(C₆H₅), C(CF₃)(C₆F₅), C(C₆H₅)₂, CF₂-CF(CF₃), CH=CH, CF=CF, C≡C, O-C₆H₄-O, O, S, CO oder SO₂,
   wobei n = 0 bis, 10 und p = 1 bis 10; 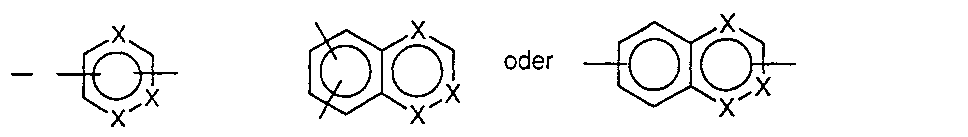
mit X = CH oder N; 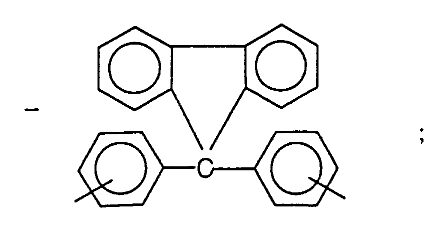 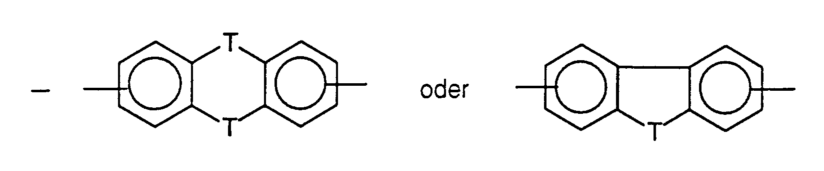
mit T = CH₂, CF₂, CO, O, S, NH oder N(CH₃) ; 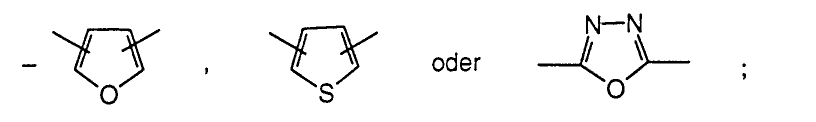 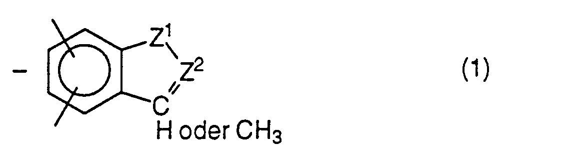
mit (a) Z¹ = CH₂ oder CH(CH₃) und Z² = CH oder C(CH₃)
   (b) Z¹ = CH₂ oder CH(CH₃) und Z² = N
   (c) Z¹ = NH oder N(CH₃) und Z² = CH oder C(CH₃)
   (d) Z¹ = NH oder N(CH₃) und Z² = N 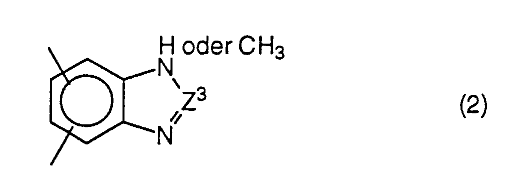
mit (a) Z³ = CH oder C(CH₃)
   (b) Z³ = N 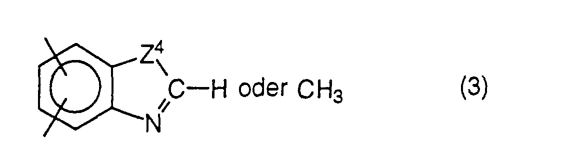
mit (a) Z⁴ = O
   (b) Z⁴ = S;
wobei an allen aromatischen Partialstrukturen jeweils sämtliche Wasserstoffatome (H) durch Fluor (F) ersetzt sein können.

Die Erfindung löst das vorstehend geschilderte Problem in der Weise, daß eine Dihydroxyverbindung mit einem Bis-o-hydroxyamid (Dihydroxydiamid) bzw. einem Bis-o-mercaptoamid (Dimercaptodiamid) umgesetzt wird; die Herstellung von Polybenzoxazol- und Polybenzothiazol-Vorstufen nach einem derartigen Verfahren ist bislang nicht bekannt. Bei diesem Verfahren ergibt sich überraschenderweise eine selektive Reaktion zwischen den eingesetzten Monomeren. Die erfindungsgemäß hergestellten Polymere, d.h. die Poly-o-hydroxy- und Poly-o-mercaptoamide, sind nämlich in metallionenfreien wäßrig-alkalischen Entwicklern löslich. Außerdem läuft das Verfahren nach der Erfindung ohne Gelbildung ab, so daß die genannten Polymere in organischen Lösungsmitteln gut löslich und verarbeitbar sind. Ferner werden bei diesem Verfahren Verunreinigungen wie Chlorid- und Metallionen sowie Phosphorverbindungen vermieden.

Es ist zwar bekannt, aromatische Polyether aus perfluorierten aromatischen Verbindungen und Dihydroxyverbindungen mittels eines basischen Katalysators herzustellen (WO 91/09081). Die Herstellung von hydroxylgruppenhaltigen alkalilöslichen Polymeren generell bzw. speziell von Polybenzoxazol- und Polybenzothiazol-Vorstufen nach einem derartigen Prinzip ist bislang jedoch nicht beschrieben. Auch über eine selektive Reaktion zur Erzeugung dieser alkalilöslichen Vorstufen aus Dihydroxydiamiden und Dihydroxyverbindungen finden sich keine Hinweise.

Das Verfahren nach der Erfindung zeigt nicht nur den Vorteil einer selektiven Reaktion, sondern es bietet ferner viele Möglichkeiten zur Veränderung der Polymerstruktur und somit zur Anpassung der gewünschten Eigenschaften. Bei diesem Verfahren ist nämlich die Anzahl der verfügbaren Kombinationen der Ausgangsmonomeren wesentlich größer als dies bei bekannten Verfahren der Fall ist.

Die beim Verfahren nach der Erfindung eingesetzten Diamide können jeweils aus einem Bis-o-aminophenol bzw. -thiophenol und einer Monocarbonsäure bzw. einem Säurederivat hergestellt werden. Da die Anzahl an verfügbaren Monocarbonsäuren viel größer ist als diejenige von Dicarbonsäuren, besteht somit bei der Umsetzung von Diamiden mit Dihydroxyverbindungen eine größere Auswahlmöglichkeit.

Die Monocarbonsäuren weisen die Struktur L-COOH auf, wobei L für einen substituierten Phenylrest steht. Die Substituenten können dabei F, CN oder NO₂ sein, wobei F bevorzugt ist. So ist die Monocarbonsäure vorteilhaft eine Perfluorbenzoesäure, d.h. Pentafluorbenzoesäure.

Besonders geeignete Bis-o-aminophenole sind 2,2-Bis-(3-amino-4-hydroxyphenyl)-hexafluorpropan und 3,3'-Dihydroxy-4,4'-di-aminodiphenyl. Zur Synthese von Poly-o-mercaptoamiden dienen die entsprechenden Bis-o-aminothiophenole. Prinzipiell können aber alle Bis-o-aminophenole und -thiophenole eingesetzt werden, die üblicherweise zur Herstellung von Polybenzoxazol- bzw. Polybenzothiazol-Vorstufen Verwendung finden.

Die durch die Reaktion von Bis-o-amino(thio)phenolen mit Monocarbonsäuren hergestellten Diamide können in einfacher Weise gereinigt werden, beispielsweise durch Umkristallisation oder Extraktion. Auf diese Weise können, soweit erforderlich, ionische oder organische Verunreinigungen leicht entfernt werden.

Die Dihydroxy- bzw. Dimercaptodiamide werden mit einer Dihydroxyverbindung umgesetzt. Die Dihydroxyverbindung kann dabei in weiten Grenzen variiert werden, wobei Bisphenole bevorzugt sind.

Die Umsetzung des Diamids mit der Dihydroxyverbindung erfolgt in Gegenwart eines basischen Katalysators. Dieser Katalysator ist vorteilhaft ein anorganisches Carbonat wie Natrium- und Kaliumcarbonat (Na₂CO₃ bzw. K₂CO₃). Vorteilhaft kann der basische Katalysator aber auch ein tertiäres Amin sein. Derartige Katalysatoren sind insbesondere Pyridin, Triethylamin, Diazabicyclooctan und Polyvinylpyridin. Es können aber auch andere basische Katalysatoren verwendet werden, wobei solche bevorzugt sind, welche in dem bei der Synthese der Vorstufe verwendeten Lösungsmittel, wie N-Methylpyrrolidon, oder in Wasser bzw. Wasser/Alkohol-Mischungen (Fällungsmittel) gut löslich sind

Die Reaktionstemperatur bei der Umsetzung zwischen dem Diamid und der Dihydroxyverbindung beträgt vorzugsweise zwischen 60 und 150°C.

Bei der basenkatalysierten Umsetzung des Diamids mit der Dihydroxyverbindung erfolgt eine Reaktion der Hydroxylgruppen der Dihydroxyverbindung mit Fluor-, Cyan- oder Nitrogruppen der aus der Monocarbonsäure stammenden substituierten Phenylreste des Diamids, die an die Amidgruppierungen gebunden sind. Dabei werden dann Gruppierungen der Art -NH-CO-L*-O-R*-O-L*-CO-NH- gebildet, wobei L* den um den ausgetretenen Substituenten (F, CN bzw. NO₂) verminderten Rest L bedeutet. Diesen Gruppierungen ist dann in o-Stellung jeweils eine OH- oder SH-Gruppe benachbart, so daß bei einer Temperung Polymere mit Benzoxazol- bzw. Benzothiazolstrukturen erhalten werden.

Geeignete Lösungsmittel sind im übrigen Dimethylformamid, N,N-Dimethylacetamid, Dimethylsulfoxid und N-Methylpyrrolidon. Prinzipiell kann jedoch jedes Lösungsmittel verwendet werden, in dem die Ausgangskomponenten gut löslich sind. Als Fällungsmittel sind Wasser und Mischungen von Wasser mit Alkoholen wie Ethanol und Isopropanol besonders geeignet.

Anhand von Ausführungsbeispielen soll die Erfindung noch näher erläutert werden.

### Beispiel 1

### Herstellung einer PBO-Vorstufe

In einen 100 ml-Dreihalskolben werden unter Stickstoff (als Schutzgas) 1,95 g 4,4'-(Hexafluorisopropyliden)-diphenol (5,8 mmol), d.h. Bisphenol AF, 0,76 g Kaliumcarbonat (5,5 mmol) und 30 ml trockenes Dimethylformamid gegeben, und dann wird 1 h bei 120°C gerührt. Man läßt auf 80°C abkühlen und tropft anschließend, gelöst in 20 ml Dimethylformamid, 4,0 g eines Dihydroxydiamids (5,3 mmol) zu, das aus 2,2-Bis-(3-amino-4-hydroxyphenyl)-hexafluorpropan und Pentafluorbenzoesäure hergestellt wurde. Die Lösung wird dann 20 h bei 80°C gerührt. Nach dem Abkühlen auf Raumtemperatur wird die hellbraune Reaktionslösung filtriert und in 500 ml einer Mischung aus drei Volumenteilen Wasser und einem Volumenteil Isopropanol (als Fällungsmittel) gegeben. Das ausgefallene weiße Polymer wird abfiltriert und zweimal mit je 200 ml Wasser gewaschen. Dann wird das Polymer getrocknet, und zwar zunächst bei 10 mbar und dann bei 10⁻² mbar, jeweils bei 50°C. Die Ausbeute beträgt 4,44 g.

### Beispiel 2

### Löslichkeit der PBO-Vorstufe und Filmbildung

1 g der nach Beispiel 1 hergestellten PBO-Vorstufe wird in 4 g N-Methylpyrrolidon gelöst und die Lösung in eine Plastikspritze gegeben, die mit einem Vorfilter versehen ist. Die Polymerlösung wird dann mittels der Spritze auf einen gereinigten und getrockneten Siliciumwafer aufgetragen und dieser in einer Schleuderapparatur (Fa. Convac, Typ ST 146) geschleudert. Anschließend wird auf einer Heizplatte bei 115°C getrocknet, wobei sich auf dem Wafer ein gleichmäßiger Film bildet. Nach dem Abkühlen wird der mit dem Polymerfilm beschichtete Wafer in einen kommerziell erhältlichen metallionenfreien wäßrig-alkalischen Entwickler (NMD-W, 2,38 %, Fa. Tokyo Ohka) getaucht. Hierbei löst sich der Polymerfilm gleichmäßig auf, d.h. ohne Rißbildungen und ohne abzuplatzen. Bereits nach kurzer Zeit ist der ganze Polymerfilm vollständig im Entwickler gelöst. Das gleiche Ergebnis wird erhalten, wenn anstelle des vorstehend genannten Entwicklers eine 3 %ige Lösung von Tetramethylammoniumhydroxid in destilliertem Wasser verwendet wird.

Eine entsprechende Lösung der PBO-Vorstufe wird auf einen Siliciumwafer aufgeschleudert, bei 115°C getrocknet und dann in einem Temperofen (HS 337, Fa. Seiter) bei 350°C unter Stickstoff getempert. Dabei entsteht ein gleichmäßiger hochtemperaturbeständiger Film aus Polybenzoxazol.

### Beispiel 3

### Herstellung einer PBO-Vorstufe

In einen 100 ml-Dreihalskolben werden unter Stickstoff (als Schutzgas) 1,2 g Bis-(4-hydroxyphenyl)-propan (5,4 mmol), d.h. Bisphenol A, 4,0 g eines Dihydroxydiamids (5,4 mmol) entsprechend Beispiel 1, 0,72 g Triethylamin (7,0 mmol) und 50 ml trockenes Dimethylformamid gegeben, dann wird auf 80°C erwärmt und 20 h bei dieser Temperatur gerührt. Nach dem Abkühlen auf Raumtemperatur wird die hellbraune Reaktionslösung filtriert und in 400 ml einer Mischung aus drei Volumenteilen Wasser und einem Volumenteil Isopropanol (als Fällungsmittel) gegeben. Das ausgefallene weiße Polymer wird abfiltriert und zweimal mit je 200 ml Wasser gewaschen. Dann wird das Polymer getrocknet, und zwar zunächst bei 10 mbar und dann bei 10⁻² mbar, jeweils bei 50°C. Die Ausbeute beträgt 3,3 g.

### Beispiel 4

### Löslichkeit der PBO-Vorstufe und Filmbildung

Wird mit der nach Beispiel 3 hergestellten PBO-Vorstufe wie in Beispiel 2 verfahren, so werden die gleichen Ergebnisse erhalten, d.h. die PBO-Vorstufe löst sich in beiden metallionenfreien wäßrig-alkalischen Entwicklern gleichmäßig auf und sie zeigt eine gute Filmbildung.

## Patentansprüche

1. Verfahren zur Herstellung von Poly-o-hydroxyamiden und Poly-o-mercaptoamiden, **dadurch gekennzeichnet**, daß ein Bis-o-hydroxyamid bzw. ein Bis-o-mercaptoamid der Struktur 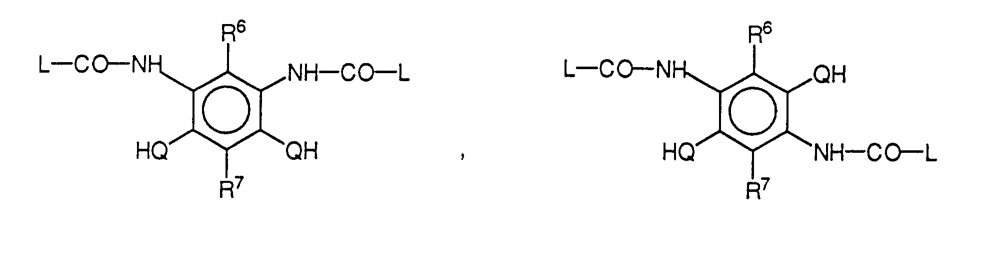 oder 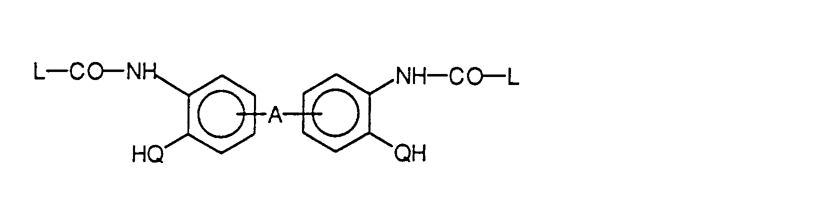 in Gegenwart eines basischen Katalysators mit einer Dihydroxyverbindung der Struktur
HO-R*-OH
umgesetzt wird, wobei folgendes gilt:
Q = O oder S;
R⁶ und R⁷ = H, F, CH₃, CF₃, CN oder NO₂ (unabhängig voneinander);
A = (CH₂)ₙ, (CF₂)ₚ, C(CH₃)₂, C(CF₃)₂, C(CH₃)(C₆H₅), C(CF₃)(C₆H₅), C(CF₃)(C₆F₅), C(C₆H₅)₂, CF₂-CF(CF₃), CH=CH, CF=CF, C≡C, O-C₆H₄-O, O, S, CO oder SO₂,
wobei n = 0 bis 10 und p = 1 bis 10; 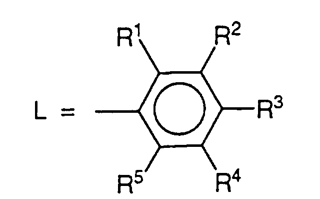 R¹, R², R³, R⁴ und R⁵ sind - unabhängig voneinander - H, F, CN oder NO₂, wobei mindestens einer der Reste R¹ bis R⁵ F, CN oder NO₂ ist und höchstens zwei der Reste R¹ bis R⁵ CN bzw. NO₂ sind;
R* hat folgende Bedeutung:
- (CR₂)ₘ mit R = H, F, CH₃ oder CF₃
und m = 1 bis 10; 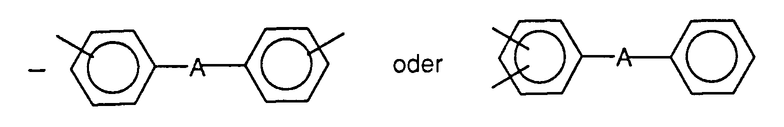
mit A = (CH₂)ₙ, (CF₂)ₚ, C(CH₃)₂, C(CF₃)₂, C(CH₃)(C₆H₅), C(CF₃)(C₆H₅), C(CF₃)(C₆F₅), C(C₆H₅)₂, CF₂-CF(CF₃), CH=CH, CF=CF, C≡C, O-C₆H₄-O, O, S, CO oder SO₂,
wobei n = 0 bis 10 und p = 1 bis 10; 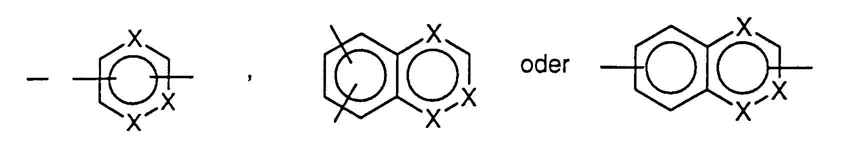
mit X = CH oder N; 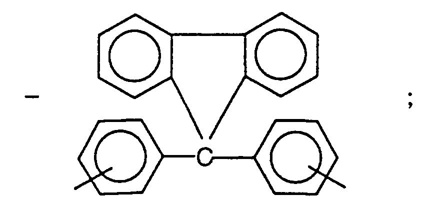 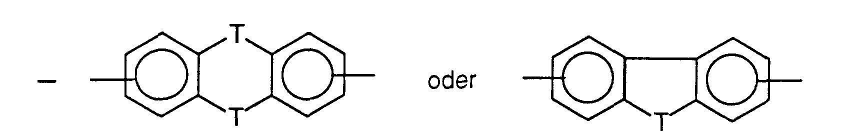
mit T = CH₂, CF₂, CO, O, S, NH oder N(CH₃); 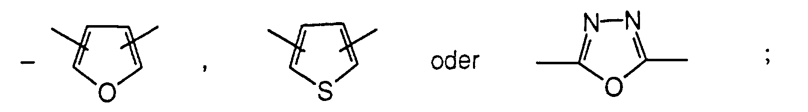 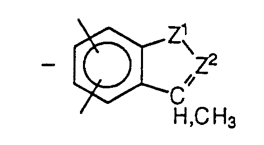
mit Z¹ = CH₂ oder CH(CH₃) und Z² = CH oder C(CH₃)
Z¹ = CH₂ oder CH(CH₃) und Z² = N
Z¹ = NH oder N(CH₃) und Z² = CH oder C(CH₃)
Z¹ = NH oder N(CH₃) und Z² = N 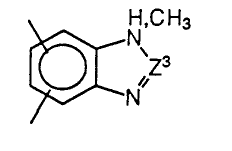
mit Z³ = CH, C(CH₃) oder N 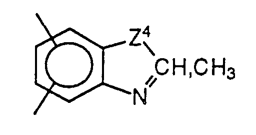
mit Z⁴ = O oder S;
wobei an allen aromatischen Partialstrukturen jeweils sämtliche Wasserstoffatome (H) durch Fluor (F) ersetzt sein können.

2. Verfahren nach Anspruch 1, **dadurch gekennzeichnet**, daß ein Bis-o-hydroxyamid aus 2,2-Bis-(3-amino-4-hydroxyphenyl)-hexafluorpropan und Pentafluorbenzoesäure eingesetzt wird.

3. Verfahren nach Anspruch 1 oder 2, **dadurch gekennzeichnet**, daß als Dihydroxyverbindung ein Bisphenol eingesetzt wird.

4. Verfahren nach einem der Ansprüche 1 bis 3, **dadurch gekennzeichnet**, daß der Katalysator Natriumcarbonat oder Kaliumcarbonat ist.

5. Verfahren nach einem der Ansprüche 1 bis 3, **dadurch gekennzeichnet**, daß der Katalysator ein tertiäres Amin ist.

6. Verfahren nach einem der Ansprüche 1 bis 5, **dadurch gekennzeichnet**, daß die Umsetzung bei Temperaturen von 60 bis 150°C durchgeführt wird.

## Claims

1. Process for the preparation of poly-o-hydroxyamides and poly-o-mercaptoamides, characterized in that a bis-o-hydroxyamide or a bis-o-mercaptoamide with the structure 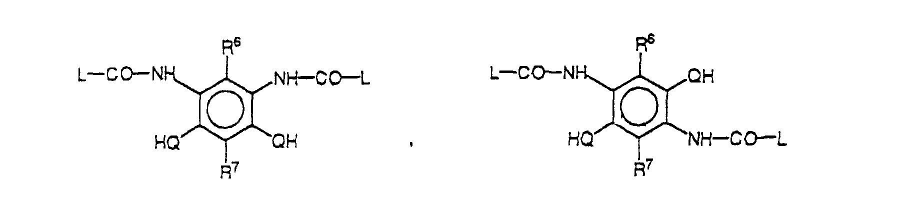 or 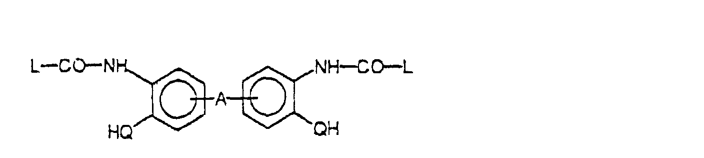 is reacted in the presence of a basic catalyst with a dihydroxy compound with the structure
HO-R*-OH,
where the following applies:
Q = O or S;
R⁶ and R⁷ = H, F, CH₃, CF₃, CN, or NO₂ (independently of each other) ;
A = (CH₂)ₙ, (CF₂)ₚ, C(CH₃)₂, C(CF₃)₂, C(CH₃) (C₆H₅), C(CF₃) (C₆H₅), C(CF₃) (C₆F₅), C(C₆H₅)₂, CF₂-CF(CF₃), CH=CH, CF=CF, C/C, O-C₆H₄-O, O, S, CO, or SO₂,
where n = 0 to 10 and p = 1 to 10; 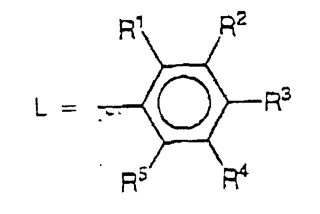 R¹, R², R³, R⁴, and R⁵ are, independently of each other, H, F, CN, or NO₂, where at least one of the groups R¹ to R⁵ is F, CN, or NO₂ and no more than two of the groups R¹ to R⁵ are CN or NO₂;
R* has the following meaning:
- (CR₂)ₘ, where R = H, F, CH₃, or CF₃
and m = 1 to 10 ; 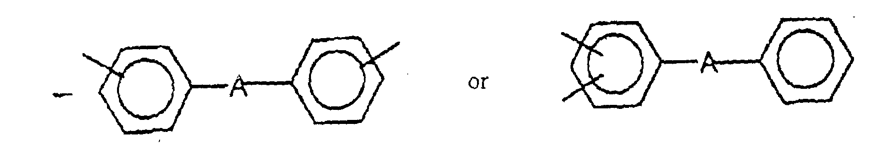
where A = (CH₂)ₙ, (CF₂)ₚ, C(CH₃)₂, C(CF₃)₂, C(CH₃) (C₆H₅) , C(CF₃) (C₆H₅), C(CF₃) (C₆F₅), C(C₆H₅)₂, CF₂-CF(CF₃), CH=CH, CF=CF, C/C, O-C₆H₄-O, O, S, CO, or SO₂,
where n = 0 to 10 and p = 1 to 10; 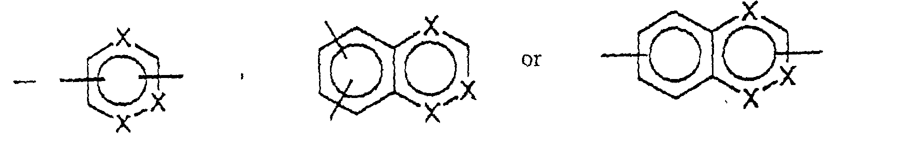
where X = CH or N; 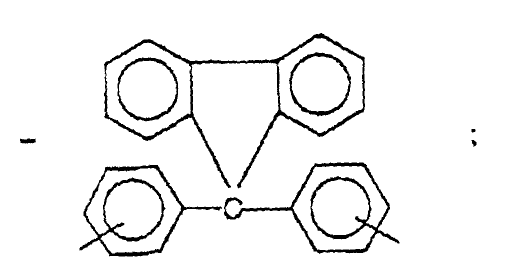 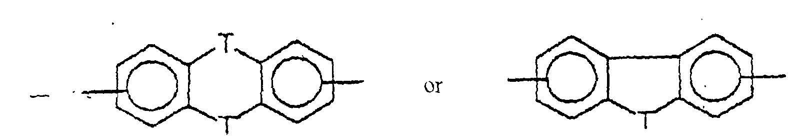
where T = CH₂, CF₂, CO, O, S, NH, or N(CH₃) ; 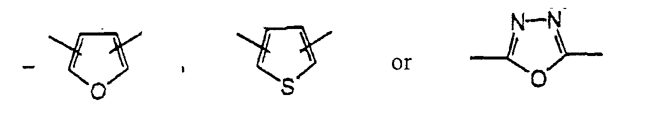 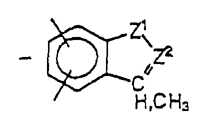
where Z¹ = CH₂ or CH(CH₃) and Z² = CH or C(CH₃)
Z¹ = CH₂ or CH(CH₃) and Z² N
Z¹ = NH or N(CH₃) and Z² = CH or C(CH₃)
Z¹ = NH or N(CH₃) and Z² = N 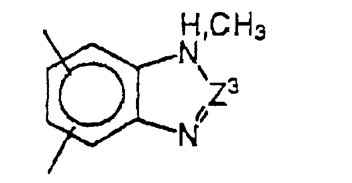
where Z³ = CH, C(CH₃), or N 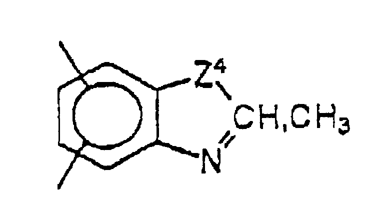
where Z⁴ = O or S;
where, in each case, all hydrogen atoms (H) in all aromatic partial structures can be replaced by fluorine (F) .

2. Process according to Claim 1, characterized in that a bis-o-hydroxyamide is prepared from 2,2-bis(3-amino-4-hydroxyphenyl)hexafluoropropane and pentafluorobenzoic acid.

3. Process according to Claim 1 or 2, characterized in that the dihydroxy compound used is a bisphenol.

4. Process according to one of Claims 1 to 3, characterized in that the catalyst is sodium carbonate or potassium carbonate.

5. Process according to one of Claims 1 to 3, characterized in that the catalyst is a tertiary amine.

6. Process according to one of Claims 1 to 5, characterized in that the reaction is carried out at temperatures of from 60 to 150°C.

## Revendications

1. Procédé de préparation de poly-o-hydroxyamides et de poly-o-mercaptoamides, caractérisé en ce qu'il consiste à faire réagir un bis-o-hydroxyamide ou un bis-o-mercaptoamide de structure 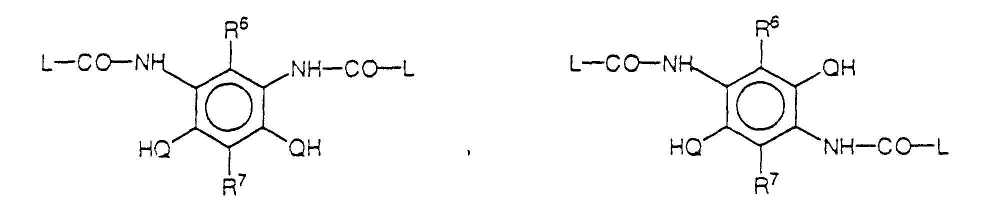 ou 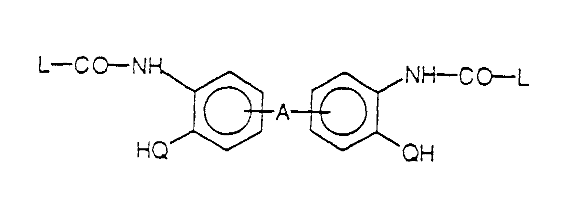 en présence d'un catalyseur basique sur un composé dihydroxylé de structure
HO-R*-OH
dans lesquelles :
Q = O ou S ;
R⁶ et R⁷ = H, F, CH₃, CF₃, CN ou NO₂ (indépendamment l'un de l'autre) ;
A = (CH₂)ₙ, (CF₂)ₚ, C(CH₃)₂, C(CF₃)₂, C(CH₃) (C₆H₅), C(CF₃) (C₆H₅), C(CF₃) (C₆F₅), C(C₆H₅)₂, CF₂-CF(CF₃), CH=CH, CF=CF, C≡C, O-C₆H₄-O, O, S, CO ou SO₂,
avec n = 0 à 10 et p = 1 à 10 ; 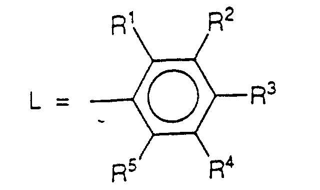 R¹, R², R³, R⁴ et R⁵ sont indépendamment les uns des autres H, F, CN ou NO₂, l'un au moins des radicaux R¹ à R⁵ étant F, CN ou NO₂ et deux au plus des radicaux R¹ à R⁵ étant C, N ou NO₂;
R* a la signification suivante :
- (CR₂)ₘ avec R = H, F, CH₃ ou CF₃
et m = 1 à 10; 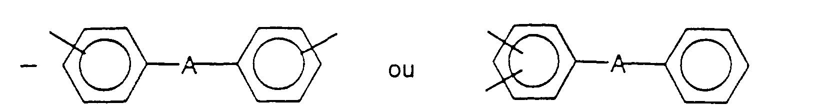
avec A = (CH₂)ₙ, (CF₂)ₚ, C(CH₃)₂, C(CF₃)₂, C(CH₃) (C₆H₅), C(CF₃) (C₆H₅), C(CF₃) (C₆F₅), C(C₆H₅)₂, CF₂-CF(CF₃), CH=CH, CF=CF, C≡C, O-C₆H₄-O, O, S, CO ou SO₂,
avec n = 0 à 10 et p = 1 à 10 ; 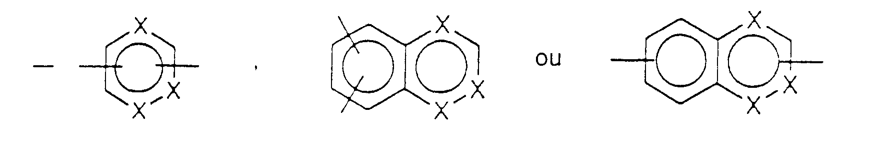
avec X = CH ou N ; 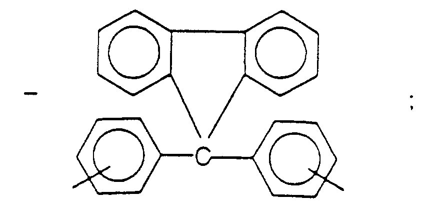 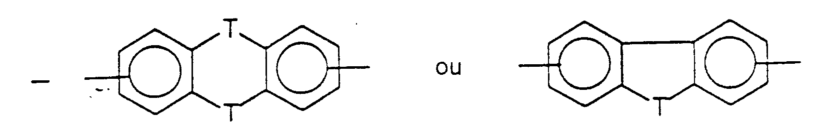
avec T = CH₂, CF₂, CO, O, S, NH ou N(CH₃) ; 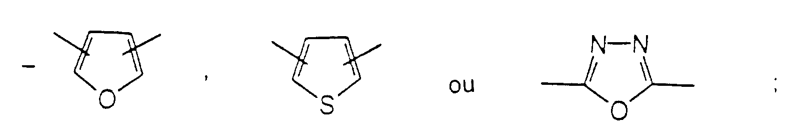 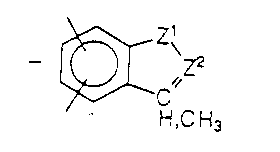
avec Z¹ = CH₂ ou CH(CH₃) et Z² = CH ou C(CH₃)
Z¹ = CH₂ ou CH(CH₃) et Z² = N
Z¹ = NH ou N(CH₃) et Z² = CH ou C(CH₃)
Z¹ = NH ou N(CH₃) et Z² = N 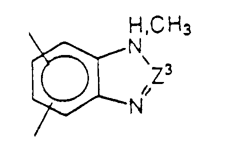
avec Z³ = CH, C(CH₃) ou N 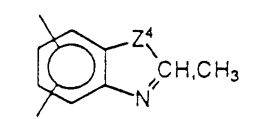
avec Z⁴ = O ou S;
respectivement tous les atomes d'hydrogène (H) des structures aromatiques partielles pouvant être remplacés par du fluor (F).

2. Procédé suivant la revendication 1, caractérisé en ce qu'il consiste à utiliser un bis-o-hydroxyamide constitué de 2,2-bis-(3-amino-4-hydroxyphényl)-hexafluoropropane et d'acide pentafluorobenzoïque.

3. Procédé suivant la revendication 1 ou 2, caractérisé en ce qu'il consiste à utiliser comme composé dihydroxylé un bisphénol.

4. Procédé suivant l'une des revendications 1 à 3, caractérisé en ce que le catalyseur est du carbonate de sodium ou du carbonate de potassium.

5. Procédé suivant l'une des revendications 1 à 3, caractérisé en ce que le catalyseur est une amine tertiaire.

6. Procédé suivant l'une des revendications 1 à 5, caractérisé en ce qu'il consiste à effectuer la réaction des températures de 60 à 150°C.
